# DEMANDE DE BREVET EUROPEEN

(11) **EP 4 198 165 A1**
(43) Date de publication de la demande: **21.06.2023**
(21) Numéro de dépôt: 22213619.4
(22) Date de dépôt: 14.12.2022
(51) Int. Cl.: C23C 16/02, C23C 16/30, C23C 16/455, C23C 16/56, H01L 21/02

(54) **PROCEDE DE DEPOT PAR VOIE CHIMIQUE SOUS VIDE D'UN FILM MINCE DE SULFURE DE TUNGSTENE ET/OU DE MOLYBDENE**

(30) Priorité: 15.12.2021 FR 2113565
(71) Demandeur: Commissariat à l'énergie atomique et aux énergies alternatives, 75015 Paris (FR)
(72) Inventeur: GASSILLOUD, Rémy, 38054 GRENOBLE CEDEX 09 (FR); CADOT, Stéphane, 38054 GRENOBLE CEDEX 09 (FR)
(74) Mandataire: Gevers & Orès

(57) **Abrégé**

La présente invention concerne un procédé de dépôt sur un substrat par voie chimique sous vide d'un film mince d'un sulfure de tungstène et/ou de molybdène.

## Description

La présente invention concerne un procédé de dépôt sur un substrat par voie chimique sous vide d'un film mince d'un sulfure de tungstène et/ou de molybdène.

Les dichalcogénures de métaux de transition constituent une classe de matériaux aux propriétés uniques basées sur le haut degré d'anisotropie associé à leurs structures cristallines. Ces matériaux cristallisent en une structure en couches dans laquelle les atomes formant chaque couche sont liés de manière covalente tandis que les couches adjacentes sont maintenues faiblement par des forces de van der Waals. Pour cette raison, ces matériaux sont souvent appelés "matériaux de van der Waals".

Parmi eux, le disulfure de tungstène (WS₂) présente des propriétés électriques particulières liées à sa structure en feuillet notablement anisotrope. C'est un semi-conducteur à gap direct en monofeuillet, et à gap indirect en multifeuillet, qui présente une mobilité électronique satisfaisante dans le plan comparé au Silicium. Il dispose aussi intrinsèquement de caractéristiques de flexibilité. Ainsi, le disulfure de tungstène peut être utilisé comme couche de canal pour réaliser des transistors à couche mince flexibles, des écrans flexibles et autres. La conductivité hors-plan est aussi spécifique, ainsi le WS₂ est aussi très étudié comme alternative aux mémoires résistives aux échelles dimensionnelles ultimes, ou dimension et consommation électrique doivent être optimisées. Dans ce cas il est intégré sous forme d'une structure verticale dite sulfure-MIM (métal/insolant/métal) entre deux métaux d'électrode. Il est également utilisé en tant que substrat pour la fabrication de films minces de nitrure d'aluminium (AlN) pouvant être facilement détachés de ce substrat et ainsi transférés (Ohuchi, F. S., Fabrication of AlN Thin Film Substrates by "van der Waals Lift-off Technique, University of Washington, April 29, 1998). Différentes solutions existent pour synthétiser le WS₂, dont notamment sa synthèse sous forme de film mince sur silicium par voie chimique sous vide.

Ainsi, la synthèse du disulfure de tungstène par voie chimique sous vide (CVD) est connue de l'art antérieur. Elle fait généralement appel à un mélange hexacarbonyle de tungstène (W(CO)₆) + sulfure de dihydrogène (H₂S). Cependant, le sulfure d'hydrogène est un gaz extrêmement toxique, dont la présence, notamment en salle blanche microélectronique, n'est généralement pas souhaitée. En outre, le contrôle en épaisseur de la croissance couche 2D par couche 2D est délicate, et les films obtenus sont généralement épais (typiquement 60 feuillets ou plus), du fait d'une vitesse de croissance trop élevée. Enfin, la croissance est de type 2D/3D avec présence dans les films obtenus de grains perpendiculaires à la surface. Ainsi, il est difficile dans ces méthodes CVD d'ajuster l'épaisseur du disulfure de tungstène à un niveau nanométrique, et il est difficile de faire croître uniformément le disulfure de tungstène ayant une nanostructure bidimensionnelle sur une grande surface. Or ces caractéristiques sont hautement désirées pour leur propriétés électriques et optiques avantageuses.

À noter qu'une baisse de la température généralement utilisée pour le dépôt ALD (atomic layer déposition), par exemple jusqu'à une température inférieure à celle de décomposition du carbonyle (notamment inférieure à 200°C), ne permet pas d'obtenir des films minces non rugueux sur substrat SiO₂/Si. En effet, la nucléation homogène est difficile à obtenir car, premièrement il n'existe de pas fenêtre en température permettant d'atteindre un régime de croissance de type ALD pour l'hexacarbonyle de tungstène, qui a tendance à perdre instantanément et intégralement tous ses groupements carbonyle à une température proche de sa température de décomposition. Par ailleurs, le cœur métallique W ainsi libéré tend à réagir rapidement avec les groupes hydroxyles de surface, naturellement présents sur surface oxydée, et bloque alors la diffusivité de l'élément métallique en surface, ce qui conduit à une croissance 2D/3D.

Des températures supérieures à celles typiquement employées en CVD ont également été étudiées. Mais ces méthodes font appel à des températures supérieures ou égales à 550°C, ce qui n'est pas avantageux d'un point de vue économique et environnemental, et au sulfure de dihydrogène, discuté ci-dessus, ou à des temps de réactions très longs, encore une fois désavantageux d'un point de vue économique et environnemental.

Un objectif de l'invention est ainsi de fournir une méthode de préparation d'un film mince, uniforme, conforme et non rugueux, notamment ayant une rugosité Rₐ inférieure à 0,6 ou 0,5 nm, d'un sulfure de tungstène et/ou de molybdène, voire de disulfure.

Un autre objectif de l'invention est de fournir une méthode de préparation permettant d'obtenir de tels films minces, conformes et non rugueux, notamment ayant une rugosité Rₐ inférieure à 0,6 ou 0,5 nm, sur de grandes surfaces de substrat, par exemple sur des surfaces de 200 à 300 mm de diamètre.

Un autre objectif de l'invention est de fournir une méthode de préparation de films de sulfure, voire de disulfure, de tungstène et/ou de molybdène permettant de porter d'autres couches conformes de matériau, par exemple de nitrure d'aluminium, en leur conférant la texture désirée, en particulier non rugueuse. De façon tout-à-fait surprenante, le procédé de l'invention permet d'obtenir une croissance 2D des films de sulfure, voire de disulfure, de tungstène et/ou de molybdène, dans un plan parallèle au substrat, au contraire des procédés de l'art antérieur dans lesquels la croissance est de type 2D/3D avec des grains perpendiculaires à la surface.

Encore un autre objectif de l'invention est de fournir une méthode de préparation de films de sulfure, voire de disulfure, de tungstène et/ou de molybdène qui soit simple à mettre en œuvre, notamment susceptible d'éviter, si désiré, l'emploi de composés chimiques très toxiques, par exemple de sulfure de dihydrogène (H₂S), comme mentionné ci-dessus, un gaz extrêmement toxique. En effet, l'inhalation de sulfure d'hydrogène peut causer la dégénérescence du nerf olfactif (rendant la détection du gaz impossible) et provoquer rapidement une perte de connaissance puis la mort.

Encore un autre objectif de l'invention est de fournir une méthode de préparation de films de sulfure, voire de disulfure, de tungstène et/ou de molybdène qui soit possible de mettre en œuvre à des températures inférieures à 500°C, voire inférieures ou égales à 410°C. Ceci permet de ne pas exposer les substrats à des hautes températures, notamment de 500°C ou plus, permettant ainsi de traiter des substrats sensibles voire instables à ces hautes températures. En outre, ces hautes températures sont désavantageuses d'un point de vue économique et environnemental.

### OBJET DE L'INVENTION

Ainsi, selon un premier aspect, l'invention concerne un procédé de formation, sur une surface d'un substrat, par voie chimique sous vide, d'un film mince constitué de ou comprenant un composé de formule WS_{X}, MoSₓ ou Mo_{y}W_{1-y}Sₓ, avec y étant compris entre 0 et 1, et x étant compris de 1,5 à 2, comprenant les étapes suivantes :
**a)** Une étape d'introduction du substrat dans une enceinte réactionnelle sous vide, à une température de substrat comprise entre 200 et 500°C ;
**b)** Une étape de préparation du substrat comprenant l'injection d'un gaz à base de, pris individuellement ou en mélange, dihydrogène, hélium, argon, diazote ou NH₃ ;
**c)** Une étape d'injection, dans l'enceinte réactionnelle, d'un mélange gazeux constitué de ou comprenant un hexacarbonyle de tungstène et/ou un hexacarbonyle de Mo, et au moins un élément azote et éventuellement au moins un élément hydrogène, ou d'injection simultanée d'hexacarbonyle de tungstène et/ou un hexacarbonyle de Mo, et d'au moins un élément azote et éventuellement d'au moins un élément hydrogène,
**d)** Une étape de purge dudit mélange gazeux ;
**e)** Une étape de mise en contact, du substrat traité tel qu'obtenu à l'issue de l'étape c) avec un gaz soufré comportant au moins un groupement thiol libre ou formant un intermédiaire réactionnel comportant au moins un groupement thiol libre, pour former sur le substrat une couche comprenant le composé de formule WS_{X}, MoSₓ ou Mo_{y}W_{1-y}Sₓ.

Selon un mode de réalisation, l'étape c) est une étape d'injection, dans l'enceinte réactionnelle, d'un mélange gazeux constitué de ou comprenant un hexacarbonyle de tungstène et/ou un hexacarbonyle de Mo, et au moins un élément azote, ou d'injection simultanée d'hexacarbonyle de tungstène et/ou d'hexacarbonyle de Mo, et d'au moins un élément azote.

Selon un autre mode de réalisation, l'étape c) est une étape d'injection, dans l'enceinte réactionnelle, d'un mélange gazeux constitué de ou comprenant un hexacarbonyle de tungstène et/ou un hexacarbonyle de Mo, et au moins un élément azote et au moins un élément hydrogène, ou d'injection simultanée d'hexacarbonyle de tungstène et/ou d'hexacarbonyle de Mo, et d'au moins un élément azote et d'au moins un élément hydrogène.

Selon un mode de réalisation, l'étape c) conduit à la formation sur le substrat de nitrure de tungstène et/ou de molybdène.

Selon un mode de réalisation, l'étape e) est réalisée à saturation en gaz soufré pour convertir totalement ou substantiellement le nitrure de tungstène et/ou de molybdène formé à l'issue de l'étape c) en composé de formule WS_{X}, MoSₓ ou Mo_{y}W_{1-y}Sₓ tel que défini précédemment. Selon un mode de réalisation, x est supérieur ou égal à 1,7.

Selon un mode de réalisation, le substrat est choisi parmi silicium, silice, nitrure de silicium, oxydes métalliques, et nitrures métalliques.

Selon un mode de réalisation, le substrat est du silicium ou de la silice, en particulier du silicium. Selon un mode de réalisation, le substrat est choisi parmi le nitrure de silicium SiN et les nitrures métalliques, en particulier les nitrures d'élément(s) III, IV, V ou VI, notamment AlN, TiN, ZrN, HfN, VN, WN, NbN, et TaN, les substrat étant plus particulièrement SiN, TiN, WN ou AlN. Selon un mode de réalisation, le substrat est choisi parmi les oxydes métalliques, en particulier les oxydes d'élément(s) III, IV, V ou VI, notamment Al₂O₃, HfO₂, TiO₂, et les oxydes de métal semi-noble, notamment CoO, NiO, Cu₂O, CuO, et ZnO.

Selon un mode de réalisation, au moins une des étapes ou l'ensemble des étapes est effectuée à une température comprise entre 360 et 450°C, en particulier à environ 410°C.

Selon un mode de réalisation, le gaz de l'étape b) est du dihydrogène, de l'argon, un mélange dihydrogène-argon, du diazote, de l'ammoniac, un mélange diazote-dihydrogène, un mélange diazote-ammoniac, un mélange dihydrogène-ammoniac, de l'hélium, un mélange dihydrogène-hélium, ou un mélange argon-hélium.

Selon un mode de réalisation, l'étape b) est réalisée sous assistance plasma, en particulier *in situ* ou déporté.

Selon un mode de réalisation, l'étape b) est réalisée pendant une durée de 2 à 900 secondes. Selon un mode de réalisation, le substrat est un nitrure de silicium ou un nitrure métallique, et l'étape b) est optionnellement réalisée sous assistance plasma, en particulier sans assistance plasma, le gaz de l'étape b) étant notamment du dihydrogène, un mélange dihydrogène-argon, de l'ammoniac, un mélange diazote-dihydrogène, un mélange diazote-ammoniac, un mélange dihydrogène-ammoniac, de l'hélium, un mélange dihydrogène-hélium, ou un mélange argon-hélium.

Selon un mode de réalisation, le substrat est du silicium ou un oxyde métallique, et l'étape b) est réalisée sous assistance plasma, en particulier *in situ* ou déporté, en particulier avec un gaz choisi parmi dihydrogène, argon, hélium, et leurs mélanges ; ou parmi diazote, ammoniac et leurs mélanges, éventuellement en présence de dihydrogène, d'argon et/ou d'hélium.

Selon un mode de réalisation, le vide est un vide primaire ou secondaire, en particulier primaire. Selon un mode de réalisation, l'étape c) est réalisée par injection d'un mélange gazeux comprenant un hexacarbonyle de tungstène et/ou un hexacarbonyle de Mo, et NH₃, ou d'injection simultanée d'hexacarbonyle de tungstène et/ou un hexacarbonyle de Mo, et de NH₃.

Selon un mode de réalisation, l'étape c) est réalisée par injection d'un mélange gazeux comprenant un hexacarbonyle de tungstène et/ou un hexacarbonyle de Mo, et au moins un élément azote et au moins un élément hydrogène, ou d'injection simultanée d'hexacarbonyle de tungstène et/ou un hexacarbonyle de Mo, et d'au moins un élément azote et d'au moins un élément hydrogène.

Selon un mode de réalisation, l'étape c) est réalisée pendant une durée de 2 à 20 secondes, en particulier d'environ 10 secondes.

Selon un mode de réalisation, l'étape d) de purge est réalisée par passage d'un gaz inerte, notamment d'argon et/ou d'hélium et/ou de diazote.

Selon un mode de réalisation, l'étape d) de purge est réalisée pendant une durée inférieure ou égale à 2 secondes.

Selon un mode de réalisation, le gaz soufré est choisi parmi éthane-1,2-dithiol (EDT), H₂S, disulfure de diméthyle (DMDS), disulfure de diéthyle (DEDS), disulfure de dipropyle (DPDS), disulfure de dibenzyle (DBDS), disulfure de di-tert-butyle (DTBDS), tert-butylthiol (t-BuSH), thiophénol et leurs mélanges.

Selon un mode de réalisation, l'étape e) est réalisée en présence de dihydrogène, et/ou d'un gaz porteur inerte, en particulier d'argon et/ou d'hélium.

Selon un mode de réalisation, l'étape e) est réalisée sous activation par plasma.

Selon un mode de réalisation particulier, l'étape e) est réalisée en présence de dihydrogène, et/ou d'un gaz porteur inerte, en particulier d'argon et/ou d'hélium et/ou de diazote, sans activation par plasma.

Selon un mode de réalisation particulier, l'étape e) est réalisée en présence de dihydrogène, et/ou d'un gaz porteur inerte, de préférence d'argon et/ou d'hélium, sous activation par plasma.

Selon un mode de réalisation, l'étape e) est réalisée pendant une durée de 1 à 20 secondes, en particulier d'environ 10 secondes.

Selon un mode de réalisation, l'étape e) est suivie d'une étape f) de purge dudit gaz soufré. Selon un mode de réalisation particulier, l'étape f) de purge est réalisée par passage d'un gaz inerte, notamment d'argon et/ou d'hélium et/ou de diazote.

Selon un autre mode de réalisation particulier, l'étape f) de purge est réalisée pendant une durée inférieure ou égale à 2 secondes.

Selon un mode de réalisation, le procédé selon l'invention comprend les étapes suivantes :
**a)** Une étape d'introduction du substrat dans une enceinte réactionnelle sous vide primaire, à une température de substrat comprise entre 200 et 500°C, notamment à une température comprise entre 360 et 450°C, en particulier à environ 410°C ;
**b)** Une étape de préparation du substrat comprenant l'injection d'un gaz à base de, pris individuellement ou en mélange, dihydrogène, hélium, argon, diazote ou NH₃, pendant une durée de 2 à 900 secondes ;
**c)** Une étape d'injection, dans l'enceinte réactionnelle, d'un mélange gazeux comprenant un hexacarbonyle de tungstène et/ou un hexacarbonyle de Mo, et NH₃, ou d'injection simultanée d'hexacarbonyle de tungstène et/ou un hexacarbonyle de Mo, et de NH₃, pendant une durée de 2 à 20 secondes, en particulier d'environ 10 secondes ;
**d)** Une étape de purge dudit mélange gazeux par passage d'un gaz inerte, notamment d'argon et/ou d'hélium, pendant une durée inférieure ou égale à 2 secondes ;
**e)** Une étape de mise en contact, du substrat traité tel qu'obtenu à l'issue de l'étape c) avec un gaz soufré comportant au moins un groupement thiol libre ou formant un intermédiaire réactionnel comportant au moins un groupement thiol libre, notamment choisi parmi éthane-1,2-dithiol (EDT), H₂S, disulfure de diméthyle (DMDS), disulfure de diéthyle (DEDS), disulfure de dipropyle (DPDS), disulfure de dibenzyle (DBDS), disulfure de di-tert-butyle (DTBDS), tert-butylthiol (t-BuSH), thiophénol et leurs mélanges pour former sur le substrat une couche comprenant le composé de formule WS_{X}, MoSₓ ou Mo_{y}W_{1-y}Sₓ, en particulier en présence de dihydrogène, et/ou d'un gaz porteur inerte, en particulier d'argon et/ou d'hélium, et/ou sous activation par plasma, pendant une durée de 1 à 20 secondes, en particulier d'environ 10 secondes :
**f)** Optionnellement, une étape de purge dudit gaz soufré par passage d'un gaz inerte, notamment d'argon et/ou d'hélium et/ou de diazote, pendant une durée inférieure ou égale à 2 secondes.

Selon un mode de réalisation, le taux résiduel d'azote de la couche obtenue à l'issue de l'étape e) est inférieur à 5% atomique.

Selon un mode de réalisation, l'épaisseur de la couche obtenue à l'issue de l'étape e) étant d'environ 0,7 Å par cycle d'étapes b) à e).

Selon un mode de réalisation, les étapes b) à e) ou éventuellement f) sont renouvelées, jusqu'à obtention du nombre de feuillets désirés, notamment 1 à 20 feuillets, en particulier de 1 à 6, par exemple 3 feuillets.

Selon un mode de réalisation, l'étape e), ou, lorsqu'elle existe, l'étape f), est suivie d'une étape de recuit, en particulier à une température de 700 °C ou plus.

Selon un autre aspect, l'invention concerne également un procédé de préparation d'un empilement de couches, comprenant les étapes a) à e) voire f) telles que définies précédemment, l'étape e), ou, lorsqu'elle existe, l'étape (f), étant suivie d'une étape de recuit, en particulier à une température de 700 °C ou plus, puis d'une étape de dépôt d'une couche d'un nitrure d'élément(s) III ou d'un composé III-V.

### DESCRIPTION DETAILLEE DE L'INVENTION

### Définitions

Tel qu'on l'entend ici, les plages de valeur sous forme de « x-y » ou « de x à y » ou « entre x et y » incluent les bornes x et y ainsi que les entiers compris entre ces bornes, et les nombres réels positifs compris entre ces bornes et/ou entiers. A titre d'exemple, « 1-5 », ou « de 1 à 5 » ou « entre 1 et 5 » désignent les entiers 1, 2, 3, 4 et 5. Les modes de réalisations préférés incluent chaque entier pris individuellement dans la plage de valeur, ainsi que toute sous-combinaison de ces entiers. A titre d'exemple, les valeurs préférées pour « 1-5 » peuvent comprendre les entiers 1, 2, 3, 4, 5, 1-2, 1-3, 1-4, 1-5, 2-3, 2-4, 2-5, etc.

Par « film mince », on entend en particulier une couche constituée de ou comprenant un composé de formule WS_{X}, MoSₓ ou Mo_{y}W_{1-y}Sₓ, avec y étant compris entre 0 et 1, et x étant compris de 1,5 à 2, notamment supérieur ou égal à 1,7. C'est sous la forme de cette couche qu'est susceptible de se former ledit composé par dépôt chimique sous vide.

Par « dépôt chimique sous vide », on entend en particulier un dépôt chimique en phase vapeur (ou CVD pour « *Chemical Vapor deposition* »)*.*

Par « enceinte réactionnelle sous vide », on entend notamment une chambre dépôt chimique sous vide, ou chambre CVD.

Par « rugosité Rₐ », on entend notamment la distance moyenne entre la ligne moyenne et les pics et les creux d'une surface donnée. Il s'agit donc notamment, pour une surface donnée, de l'écart moyen, ou moyenne arithmétique des distances entre pics et creux successifs.

"Ra" correspond ainsi en particulier à la différence entre cette distance moyenne et la "ligne centrale".

La rugosité Rₐ peut notamment être évaluée par microscope à force atomique (AFM) ou par réflectivité X.

Cette rugosité est par exemple mesurée par AFM, sur un scan caractéristique de 1^{∗}1 µm et une extraction par moyenne arithmétique ou moment d'ordre 2.

### Le procédé de croissance selon l'invention

Selon le présent procédé par voie chimique sous vide, un film mince est formé et croît sur un substrat placé dans une chambre de réaction à des températures élevées. Les principes généraux de la voie chimique sous vide sont bien connus de l'homme du métier.

Lorsqu'est utilisé dans l'étape c) un mélange gazeux comprenant un hexacarbonyle de tungstène et NH₃ (ou un mélange gazeux tel que défini plus bas), est formé sur le substrat, à l'issue de l'étape e), une couche comprenant le composé de formule WSₓ tel que défini précédemment. Lorsqu'est utilisé dans l'étape c) un mélange gazeux comprenant un hexacarbonyle de molybdène et NH₃ (ou un mélange gazeux tel que défini plus bas), est formé sur le substrat, à l'issue de l'étape e), une couche comprenant le composé de formule MoSₓ tel que défini précédemment.

Lorsqu'est utilisé dans l'étape c) un mélange gazeux comprenant un hexacarbonyle de tungstène, un hexacarbonyle de molybdène et NH₃ (ou un mélange gazeux tel que défini plus bas), est formé sur le substrat, à l'issue de l'étape e), une couche comprenant le composé de formule Mo_{y}W_{1-y}Sₓ tel que défini précédemment.

Sans vouloir se limiter à une quelconque théorie, le mélange gazeux de l'étape c) conduit à la formation sur le substrat de nitrure de tungstène et/ou de molybdène, lequel est converti totalement ou substantiellement à l'issue de l'étape e) en composé de formule WSₓ, MoSₓ ou Mo_{y}W_{1-y}Sₓ tel que défini ci-dessus.

La valeur x peut par exemple, et si nécessaire, être modifiée en modifiant la température à laquelle est porté le substrat, laquelle est définie ci-dessous. Par exemple, une température de 360°C, 410°C et 450°C est susceptible de permettre l'obtention d'une valeur x d'environ 2, 1,7 et 1,6 environ, respectivement.

### Introduction du substrat dans l'enceinte

Comme défini ci-dessus, le substrat est placé dans une enceinte réactionnelle sous vide, de telle façon à ce qu'il soit sous vide, à une température comprise entre 200 et 500°C, pour les étapes suivantes.

Cette température de substrat peut être constante ou substantiellement constante au cours des étapes. Cette température de substrat peut également être différente pour au moins une de ces étapes, tout en étant encore comprise entre 200 et 500°C.

### Étape de préparation du substrat

Par « nitrure d'élément(s) III, IV, V ou VI », on entend notamment un nitrure d'au moins un élément de la colonne III B (bore, gallium, aluminium, indium, etc.) du tableau périodique de Mendeleïev, notamment AlN, un nitrure d'au moins un élément de la colonne IV A (titane, zirconium, hafnium, etc.) du tableau périodique de Mendeleïev, notamment TiN, HfN et ZrN, un nitrure d'au moins un élément de la colonne V A (vanadium, niobium, tantale, etc.) du tableau périodique de Mendeleïev, notamment VN, NbN et TaN, et un nitrure d'au moins un élément de la colonne VI A (chrome, molybdène, tungstène, etc.) du tableau périodique de Mendeleïev, notamment WN, respectivement.

Par « oxyde d'élément(s) III, IV, V ou VI », on entend notamment un nitrure d'au moins un élément de la colonne III B (bore, gallium, aluminium, indium, etc.) du tableau périodique de Mendeleïev, notamment Al₂O₃, un nitrure d'au moins un élément de la colonne IV A (titane, zirconium, hafnium, etc.) du tableau périodique de Mendeleïev, notamment TiO₂ et HfO₂, un nitrure d'au moins un élément de la colonne V A (vanadium, niobium, tantale, etc.) du tableau périodique de Mendeleïev, et un nitrure d'au moins un élément de la colonne VI A (chrome, molybdène, tungstène, etc.) du tableau périodique de Mendeleïev, respectivement.

Par « oxyde de métal semi-noble », on entend par exemple CoO, NiO, Cu₂O, CuO, ou ZnO.

Le substrat est préparé à l'étape b) quelle que soit sa nature.

L'utilisation ou non d'une assistance plasma peut notamment dépendre de la nature de ce substrat.

En particulier, lorsque le substrat est un nitrure de silicium ou un nitrure métallique, ce dernier est préparé en utilisant comme gaz du dihydrogène, un mélange dihydrogène-argon, de l'ammoniac, un mélange diazote-dihydrogène, un mélange diazote-ammoniac, ou un mélange dihydrogène-ammoniac, avec ou non assistance plasma, en particulier sans assistance plasma.

Lorsque le substrat est du silicium ou un oxyde métallique, sa préparation se fait généralement sous assistance plasma, en particulier *in situ* ou déporté, en particulier avec un gaz choisi parmi dihydrogène, argon, et leurs mélanges ; ou parmi diazote, ammoniac et leurs mélanges, éventuellement en présence de dihydrogène, d'argon et/ou d'hélium.

Cette assistance plasma, en particulier in situ ou déporté, est bien connue de l'homme du métier. Elle peut par exemple apparaître sous forme d'option à sélectionner dans les dispositifs de dépôt CVD classiquement utilisés.

Par « assistance plasma in situ », on entend en particulier une assistance par plasma à couplage capacitif (CCP ou « *Capacitively Coupled Plasma* », c'est-à-dire sous décharge de plasma capacitive. En général, est appliqué un courant alternatif ou radio-fréquence entre une électrode et les parois conductrices de l'enceinte réactionnelle (ou entre deux électrodes cylindriques se faisant face). Cette dernière configuration est connue sous le nom de réacteur à plaques parallèles.

Par « assistance plasma déporté », on entend en particulier une assistance par plasma à couplage inductif (ICP ou «Inductively Coupled Plasma »). En général, le plasma inductif est obtenu et maintenu par une torche qui consiste en trois tubes concentriques, généralement faits de quartz. L'extrémité de cette torche est située à l'intérieur d'une bobine d'induction alimentée par un courant en haute fréquence. Un flux de gaz est introduit entre les deux tubes extérieurs de la torche et une étincelle génère les premiers électrons libres dans le flux de gaz.

Par « vide primaire », on entend notamment une pression comprise de 760T et 0,001T (Torr). Par « vide secondaire », on entend notamment une pression inférieure à 0,001mT.

### Etape d'injection d'un mélange gazeux comprenant un hexacarbonyle et au moins un élément azote

Par « au moins un élément azote », on entend notamment tout gaz comprenant au moins un azote et susceptible de former du nitrure de tungstène et/ou de molybdène en réaction avec un hexacarbonyle de tungstène et/ou un hexacarbonyle de Mo. Il s'agit en particulier de tout composé azoté ou mélange comprenant un composé azoté susceptible de former du NH₃ dans les conditions de température et de pression de l'enceinte réactionnelle. Il peut par exemple s'agir d'ammoniac ou d'un mélange N₂H₄ / H₂. Il peut également par exemple s'agir d'ammoniac, avec ou sans Ar, ou d'un mélange ammoniac/N₂, avec ou sans Ar.

Par « au moins un élément azote et un au moins un élément hydrogène », on entend notamment tout gaz ou mélange de gaz comprenant au moins un azote et au moins un hydrogène mélangés ensemble et susceptible de former du nitrure de tungstène et/ou de molybdène en réaction avec un hexacarbonyle de tungstène et/ou un hexacarbonyle de Mo. Il s'agit en particulier de tout composé azoté en mélange dans un gaz réducteur tel que le dihydrogène susceptible de former du NH₃, et des composés radicalaires NH₂ et NH sous activation plasma, dans les conditions de température et de pression de l'enceinte réactionnelle.

Il peut par exemple s'agir d'un mélange ammoniac/H₂ ou d'un mélange N₂H₄/H₂, ou d'un mélange de N₂ et H₂.

Par « mélange gazeux comprenant (...) au moins un élément azote », on peut également entendre un plasma N₂/H₂ avec ou sans Ar, ou d'un plasma NH₃ avec ou sans Ar, ou NH₃/N₂ avec ou sans Ar, ou NH₃/H₂ avec ou sans Ar, conduisant à la formation de radicaux NH₃, NH₂, NH

Ainsi, selon un mode de réalisation particulier, le mélange gazeux comprenant un hexacarbonyle de tungstène et/ou un hexacarbonyle de Mo comprend en sus un gaz ou un mélange gazeux choisi parmi l'ammoniac (NH₃), avec ou sans Ar, un mélange ammoniac/N₂, avec ou sans Ar, un mélange ammoniac/H₂, un mélange N₂H₄/H₂, un mélange de N₂ et H₂, un plasma N₂/H₂ avec ou sans Ar, un plasma NH₃ avec ou sans Ar, un plasma NH₃/N₂ avec ou sans Ar, un plasma NH₃/H₂ avec ou sans Ar.

L'injection du mélange gazeux lors de l'étape c) se fait selon l'une des techniques bien connues de l'homme du métier.

Il peut s'agir de l'injection du mélange gazeux lui-même, préformé.

Il peut également s'agir d'une injection simultanée de l'hexacarbonyle et du gaz ou mélange gazeux tel que décrit précédemment, notamment du NH₃. Cette co-injection est alors réalisée de façon à ce que les deux gaz ou ménages gazeux se mélangent avant contact ou au contact avec le substrat. Cette co-injection peut être réalisée par l'une des techniques bien connues de l'homme du métier.

Par NH₃, on entend en particulier de l'ammoniac, sous forme de gaz dans le cadre de la présente invention.

Sans vouloir se limiter à une quelconque théorie, et comme indiqué plus haut, le mélange gazeux de l'étape c) conduit à la formation sur le substrat de nitrure de tungstène et/ou de molybdène.

### Étape de purge du mélange gazeux

Cette étape est réalisée de façon à ce que le gaz soufré injecté comme décrit ci-après ne se mélange pas substantiellement aux gaz ou mélanges gazeux tels que décrits précédemment, notamment à l'ammoniac NH₃ et à l'hexacarbonyle de tungstène et/ou de molybdène.

La durée de cette étape d) de purge peut aisément être déterminée par l'homme du métier pour arriver à ce but. Cette durée dépend notamment du volume du réacteur ainsi que des moyens de pompage, primaire ou secondaire. Elle est typiquement inférieure ou égale à 2 secondes.

### Etape de mise en contact avec un gaz soufré

Par « groupement thiol libre », on entend en particulier un groupe -SH.

Par « formant un intermédiaire réactionnel comportant au moins un groupement thiol libre », on entend en particulier un gaz susceptible de former in situ un gaz soufré comportant au moins un groupement thiol libre. Il peut par exemple s'agir d'un composé comportant une liaison -S-S-, en présence de dihydrogène.

Ainsi, le gaz soufré est en particulier un composé gazeux comprenant un groupe -SH, ou une liaison -S-S- susceptible de former les deux groupes -SH en réaction avec du dihydrogène dans les conditions de température et de pression de l'enceinte réactionnelle.

Ce composé peut être le disulfure d'hydrogène ou un composé organique gazeux comprenant un groupe -SH ou une liaison -S-S- susceptible de former les deux groupes -SH dans les conditions de température et de pression de l'enceinte réactionnelle.

Ce composé organique est sous forme de gaz dans les conditions de température et de pression de l'enceinte réactionnelle, voire également sous forme de gaz préalablement à l'injection dans l'enceinte réactionnelle.

Le gaz soufré peut être choisi parmi 1,2-éthane di-thiol, éthane thiol, t-BuSH, thiophénol et leurs mélanges, notamment en l'absence de H₂, éventuellement avec une activation par plasma réducteur.

Le gaz soufré peut également être choisi parmi DMDS, DEDS, DPDS, DBDS, DTBDS, di-tertbuthyl disulfide, et leurs mélanges, en mélange avec H₂, et éventuellement avec une activation par plasma réducteur.

Sans vouloir se limiter à une quelconque théorie, et comme mentionné plus haut, le nitrure de tungstène et/ou de molybdène formé à l'étape c) est converti totalement ou substantiellement à l'issue de l'étape e) en composé de formule WS_{X}, MoSₓ ou Mo_{y}W_{1-y}Sₓ tel que défini ci-dessus. Par « substantiellement », on entend notamment une conversion telle que le taux résiduel d'azote de la couche obtenue à l'issue de l'étape e) est inférieur à 5% atomique.

Cette étape est notamment réalisée en présence de dihydrogène, et/ou d'un gaz porteur inerte, en particulier d'argon et/ou d'hélium ; et/ou sous activation par plasma.

Par « gaz porteur inerte », on entend notamment de l'argon et/ou de l'hélium et/ou du diazote.

### Etape de purge un gaz soufré

Cette étape, optionnelle, est réalisée pendant une durée aisément déterminable par l'homme du métier pour arriver à ce but. Elle est typiquement inférieure ou égale à 2 secondes.

Elle peut être omise, notamment pour permettre un procédé plus court.

Elle peut également être réalisée une seule fois, à l'issue du nombre de cycles d'étapes b) à e) désiré.

### Etape ultérieures éventuelles.

Une étape de recuit peut être réalisée à l'issue des étapes décrites ci-dessus. Cette étape de recuit permet en particulier de cristalliser la couche obtenue à l'issue de l'étape e) pour obtenir un film mince de WS_{X}, MoSₓ ou Mo_{y}W_{1-y}Sₓ cristallisé.

Cette étape de recuit peut être suivie d'une étape de dépôt d'une couche d'un nitrure d'élément(s) III ou d'un composé III-V, par exemple de nitrure d'aluminium, pour obtenir l'empilement de couches correspondant.

Par « nitrure d'élément(s) III », on entend notamment un nitrure d'au moins un élément de la colonne III B (bore, gallium, aluminium, indium, etc.) du tableau périodique de Mendeleïev, notamment AlN.

Par « composé III-V », on entend notamment un matériau composé d'un ou plusieurs éléments de la colonne III B (bore, gallium, aluminium, indium, etc.) et de la colonne V B (arsenic, antimoine, phosphore, etc.) du tableau périodique de Mendeleïev, tels que l'arséniure de gallium, arséniure d'indium, nitrure de gallium, antimoniure de gallium, phosphure de bore ou des alliages ternaires tels que InₐGa₁₋ₐAs.

Il est à noter que le film mince obtenu à l'issue du procédé peut être utilisé à l'état brut avec ou sans recuit, notamment pour la réalisation d'une couche active d'une mémoire en intégration Métal/Isolant/Métal (MIM).

### FIGURES

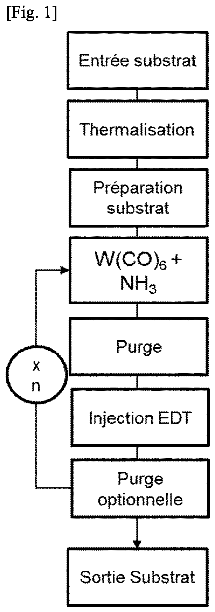

La figure 1 illustre les étapes d'un exemple de procédé de formation d'une couche de WS_{X}, MoSₓ ou Mo_{y}W_{1-y}Sₓ, avec y étant compris entre 0 et 1, et x étant compris de 1,5 à 2 par CVD selon l'invention.
La figure 2 présente la vitesse de croissance du film mince selon l'exemple 1 en fonction de la température du substrat.
La figure 3 montre l'étude de la stœchiométrie du sulfure de tungstène WSₓ obtenu selon l'exemple 1 en fonction de la température par spectroscopie de fluorescence de rayons X à dispersion de longueur d'onde (WDXRF pour « wavelength dispersive X-ray fluorescence spectroscopy »).
La figure 4 est relative à la topographie d'un carré de 1×1 µm de la surface d'un film mince après déposition selon l'exemple 1. Rugosité RMS = 0,4 nm.
La figure 5 correspond à une analyse de la surface d'un film mince après déposition selon l'exemple 1 par spectrométrie photoélectronique X (XPS) relative à W*4f* (A), *S2p* (B), N*1s* (C).

### EXEMPLES

### Exemple 1 : obtention d'un sulfure de tungstène

Dans un réacteur de dépôt CVD standard, sous vide primaire (2Torr), dans lequel a été préalablement placé un substrat de type tranche de silicium (bulk ou SOI (silicium sur isolant)), à 410°C, ledit substrat a été préparé par injection d'un gaz à base de, pris individuellement ou en mélange, de dihydrogène, hélium, argon, diazote ou de NH₃ (ammoniac), avec ou sans assistance plasma, généralement in-situ ou déporté, en particulier afin de réduire si nécessaire la durée de cette étape et donc du procédé. Cette préparation permet d'éliminer l'oxygène résiduel dans le réacteur, ainsi que les condensats humides en surface. Le cas échéant, elle a aussi pour rôle la réduction du nombre de liaisons hydroxyles sur les surfaces oxydées.

La durée de cette étape est typiquement dans la gamme 2-900s, dépendant de la présence ou non d'assistance plasma, et si oui, de l'assistance plasma choisie.

Puis ont été injectés en même temps de l'ammoniac NH₃ et de l'hexacarbonyle de tungstène W(CO)₆ (commercialement disponible).

La durée de cette étape ne doit pas excéder une valeur qui ne permettrait pas la sulfuration à cœur de la phase W_{z}N_{z'} au moment de l'exposition au gaz soufré telle que décrite plus bas. La durée de cette étape est généralement dans la gamme 2-20s, préférentiellement 10s.

A l'issue de cette étape, un film extrêmement mince de nitrure de tungstène (de type W_{z}N_{z'}) est formé.

Une étape de purge, réalisée par débit d'un gaz neutre, a ensuite été effectuée, afin que le gaz soufré injecté comme décrit ci-après ne se mélange pas à l'ammoniac NH₃ et à l'hexacarbonyle de tungstène W(CO)6 (ce qui conduirait à un mélange W_{z}N_{z'}S_{z"} que l'on ne souhaite pas atteindre, ainsi qu'à la formation incontrôlée de poudres).

Le temps de purge, et en particulier le temps de purge maximum, dépend notamment de la géométrie du réacteur, et est typiquement inférieur à 2 secondes. Ce temps de purge est adapté au dispositif utilisé pour arriver au but décrit ci-dessus.

Un gaz soufré de type 1,2 éthane di-thiol (EDT) est ensuite injecté. Ce dernier peut être utilisé pur ou en mélange avec un gaz porteur neutre. D'autres molécules de la même famille peuvent être utilisées avec succès (pures ou en mélange), en particulier, éthane thiol, DMDS, DEDS, DPDS, DBDS, DTBDS, t-BuSH, di-tertbuthyl disulfide, thiophénol, en mélange ou pas avec H₂, et éventuellement avec une activation par plasma réducteur.

Plus particulièrement, il peut s'agir de 1,2-éthane di-thiol, éthane thiol, t-BuSH ou thiophénol, notamment en l'absence de H₂, éventuellement avec une activation par plasma réducteur.

Il peut également s'agir de DMDS, DEDS, DPDS, DBDS, DTBDS, ou de di-tertbuthyl disulfide, en mélange avec H₂, et éventuellement avec une activation par plasma réducteur. Cette étape permet de convertir le nitrure de tungstène formé précédemment en sulfure de tungstène de type WS_{x,} x étant compris de 1,5 à 2.

La durée de cette étape dépend du temps de conversion du nitrure de tungstène de type W_{z}N_{z'} en en sulfure de tungstène de type WSₓ, et donc de l'épaisseur de W_{z}N_{z'}, et est généralement dans la gamme 1-20 secondes, préférentiellement 10 secondes.

Une nouvelle étape de purge, cette fois optionnelle, peut être effectuée ici.

Un cycle de croissance correspond à l'exposition séquentielle du substrat au mélange W(CO)₆ + NH₃, puis de l'EDT, l'ensemble séparé par une étape de purge. L'épaisseur finale du dépôt est obtenue en multipliant les cycles.

La vitesse de croissance dépend de la température de dépôt, dans la gamme 200-500°C, préférentiellement 360-450°C, par exemple 410°C. Il s'agit d'un régime dit de dépôt en phase chimique pulsé. Le terme pulsé décrit une solution technique où l'on expose séquentiellement le substrat à des gaz afin de limiter les interactions chimiques par mélange direct, et dans laquelle sont associées des séquences de purge en gaz neutre pour garantir la séparation des chimies.

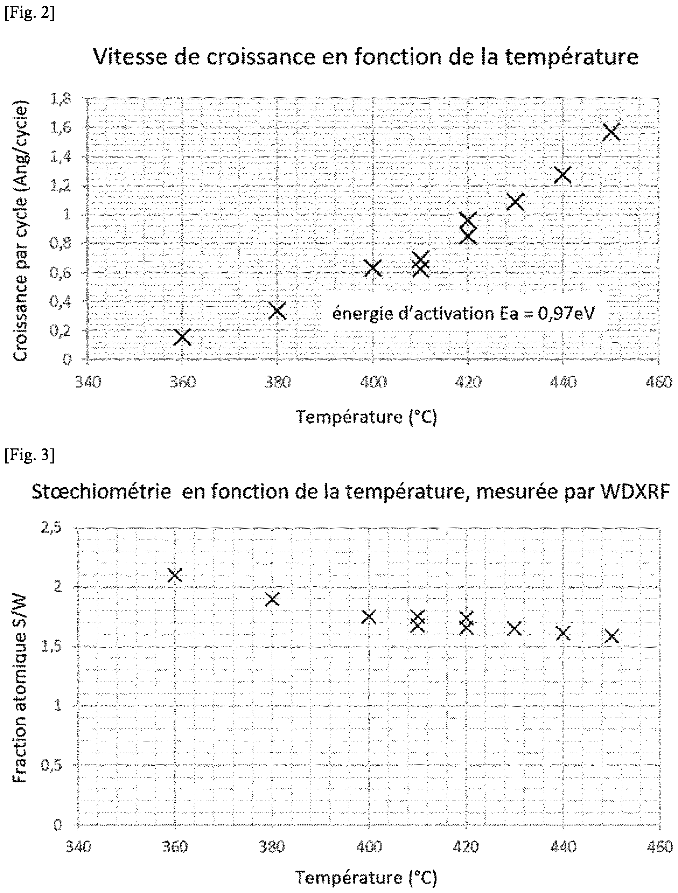

La vitesse de dépôts est de l'ordre de 0,7Ang. par cycle. Une analyse de type Arrhenius de la figure 2 permet d'extraire une énergie d'activation de l'ordre 1eV.

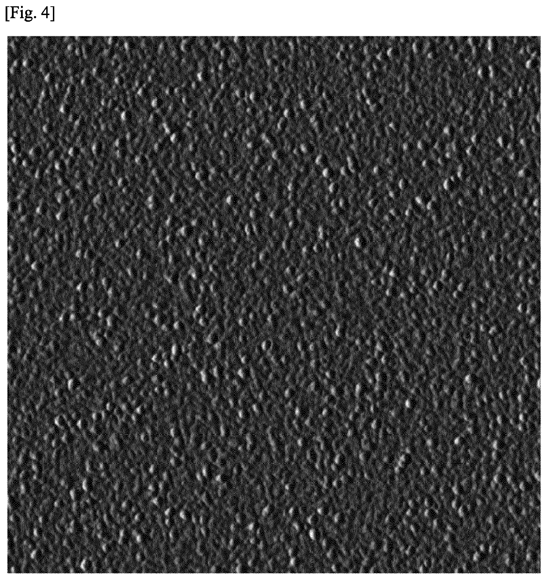

Le film obtenu est fermé, uniforme, peu rugueux, notamment ayant une rugosité Rₐ inférieure à 0,6 ou 0,5 nm, et conforme (figure 4).

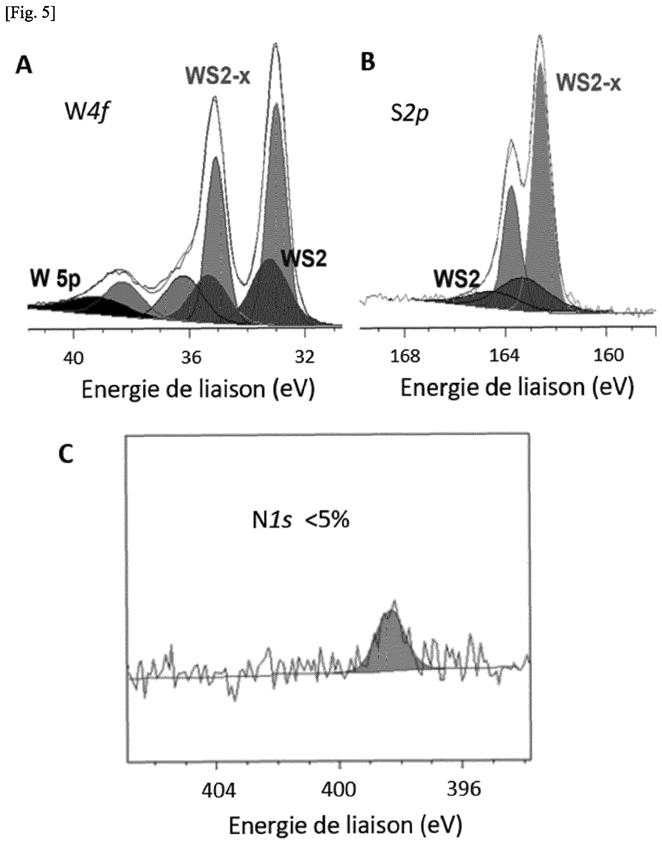

Il est à noter qu'un très faible pourcentage atomique résiduel de N (<5%) peut éventuellement être détecté par XPS dans le film après dépôt (figure 5).

Il est à noter également que la valeur x peut par exemple, et si nécessaire, être modifiée par le biais de la température à laquelle est porté le substrat. Par exemple, une température de 360°C, 410°C et 450°C est susceptible de permettre l'obtention d'une valeur x d'environ 2, 1, 7 et 1,6 environ, respectivement (figure 3).

### Exemple 2 : obtention d'un sulfure de molybdène ou d'un sulfure Mo-W

Un composé de formule MoSₓ tel que défini précédemment est obtenu avec succès selon un protocole analogue à celui décrit dans l'exemple 1, en utilisant un hexacarbonyle de molybdène à la place de l'hexacarbonyle de tungstène.

De plus, un composé de formule Mo_{y}W_{1-y}Sₓ tel que défini précédemment est obtenu avec succès selon un protocole analogue à celui décrit dans l'exemple 1, en utilisant un mélange hexacarbonyle de tungstène / hexacarbonyle de molybdène à la place de l'hexacarbonyle de tungstène.

### Exemple 3 : Mise en œuvre d'un recuit de cristallisation

Le film mince obtenu à l'issue des exemples 1 et 2 peut être utilisé avec ou sans recuit, notamment pour la réalisation d'une couche active d'une mémoire en intégration Métal/Isolant/Métal (MIM).

Ce recuit peut être nécessaire pour d'autres applications, où la présence d'un film mince cristallisé est souhaitable voire nécessaire.

Ainsi, le film mince obtenu à l'issue de l'exemple 1 ou 2 a été recuit à une température de 700 °C ou plus, avec succès, pour obtenir un film mince de WSₓ, MoSₓ ou Mo_{y}W_{1-y}Sₓ cristallisé.

## Revendications

1. Procédé de formation, sur une surface d'un substrat, par voie chimique sous vide, d'un film mince constitué de ou comprenant un composé de formule WSₓ, MoSₓ ou Mo_{y}W_{1-y}Sₓ, avec y étant compris entre 0 et 1, et x étant compris de 1,5 à 2, notamment supérieur ou égal à 1,7, comprenant les étapes suivantes :
**a)** Une étape d'introduction du substrat dans une enceinte réactionnelle sous vide, à une température de substrat comprise entre 200 et 500°C ;
**b)** Une étape de préparation du substrat comprenant l'injection d'un gaz à base de, pris individuellement ou en mélange, dihydrogène, hélium, argon, diazote ou NH₃ ;
**c)** Une étape d'injection, dans l'enceinte réactionnelle, d'un mélange gazeux comprenant un hexacarbonyle de tungstène et/ou un hexacarbonyle de Mo, et au moins un élément azote et éventuellement au moins un élément hydrogène, ou d'injection simultanée d'hexacarbonyle de tungstène et/ou un hexacarbonyle de Mo, et d'au moins un élément azote et éventuellement d'au moins un élément hydrogène,
**d)** Une étape de purge dudit mélange gazeux ;
**e)** Une étape de mise en contact, du substrat traité tel qu'obtenu à l'issue de l'étape c) avec un gaz soufré comportant au moins un groupement thiol libre ou formant un intermédiaire réactionnel comportant au moins un groupement thiol libre, pour former sur le substrat une couche comprenant le composé de formule WSₓ, MoSₓ ou
MOy W_{1-y}Sₓ.

2. Procédé selon la revendication 1, dans lequel l'étape c) conduit à la formation sur le substrat de nitrure de tungstène et/ou de molybdène, l'étape e) étant notamment réalisée à saturation en gaz soufré pour convertir totalement ou substantiellement le nitrure de tungstène et/ou de molybdène formé à l'issue de l'étape c) en composé de formule WSₓ, MoSₓ ou Mo_{y}W_{1-y}Sₓ tel que défini dans la revendication 1.

3. Procédé selon l'une quelconque des revendications précédentes, dans lequel le substrat est choisi parmi silicium, silice, nitrure de silicium, oxydes métalliques, et nitrures métalliques, le substrat étant notamment :
- du silicium ou de la silice, en particulier du silicium ;
- choisi parmi le nitrure de silicium SiN et les nitrures métalliques, en particulier les nitrures d'élément(s) III, IV, V ou VI, notamment AlN, TiN, ZrN, HfN, VN, WN, NbN, et TaN, les substrat étant plus particulièrement SiN, TiN, WN ou AlN ; ou
- choisi parmi les oxydes métalliques, en particulier les oxydes d'élément(s) III, IV, V ou VI, notamment Al₂O₃, HfO₂, TiO₂, et les oxydes des métaux semi-nobles CoO, NiO, Cu₂O, CuO, et ZnO.

4. Procédé selon l'une quelconque des revendications précédentes, dans lequel au moins une des étapes ou l'ensemble des étapes est effectuée à une température comprise entre 360 et 450°C, en particulier à environ 410°C.

5. Procédé selon l'une quelconque des revendications précédentes, dans lequel :
- le gaz de l'étape b) est du dihydrogène, de l'argon, un mélange dihydrogène-argon, du diazote, de l'ammoniac, un mélange diazote-dihydrogène, un mélange diazote-ammoniac, un mélange dihydrogène-ammoniac, de l'hélium, un mélange dihydrogène-hélium, ou un mélange argon-hélium ; et/ou
- l'étape b) est réalisée sous assistance plasma, en particulier *in situ* ou déporté ; et/ou
- l'étape b) est réalisée pendant une durée de 2 à 900 secondes.

6. Procédé selon l'une quelconque des revendications précédentes, dans lequel le substrat est :
- un nitrure de silicium ou un nitrure métallique, et l'étape b) est optionnellement réalisée sous assistance plasma, en particulier sans assistance plasma, le gaz de l'étape b) étant notamment du dihydrogène, un mélange dihydrogène-argon, de l'ammoniac, un mélange diazote-dihydrogène, un mélange diazote-ammoniac, un mélange dihydrogène-ammoniac, de l'hélium, un mélange dihydrogène-hélium, ou un mélange argon-hélium ; ou
- du silicium, ou de la silice ou un oxyde métallique, et l'étape b) est réalisée sous assistance plasma, en particulier *in situ* ou déporté, en particulier avec un gaz choisi parmi dihydrogène, argon, hélium, et leurs mélanges ; ou parmi diazote, ammoniac et leurs mélanges, éventuellement en présence de dihydrogène, d'argon et/ou d'hélium.

7. Procédé selon l'une quelconque des revendications précédentes, dans lequel le vide est un vide primaire ou secondaire, en particulier primaire.

8. Procédé selon l'une quelconque des revendications précédentes, dans lequel l'étape c) est réalisée
- par injection d'un mélange gazeux comprenant un hexacarbonyle de tungstène et/ou un hexacarbonyle de Mo, et NH₃, ou d'injection simultanée d'hexacarbonyle de tungstène et/ou un hexacarbonyle de Mo, et de NH₃ ; ou
- par injection d'un mélange gazeux comprenant un hexacarbonyle de tungstène et/ou un hexacarbonyle de Mo, et au moins un élément azote et au moins un élément hydrogène, ou d'injection simultanée d'hexacarbonyle de tungstène et/ou un hexacarbonyle de Mo, et d'au moins un élément azote et d'au moins un élément hydrogène ; et/ou
- pendant une durée de 2 à 20 secondes, en particulier d'environ 10 secondes.

9. Procédé selon l'une quelconque des revendications précédentes, dans lequel l'étape d) de purge est réalisée :
- par passage d'un gaz inerte, notamment d'argon et/ou d'hélium et/ou de diazote; et/ou
- pendant une durée inférieure ou égale à 2 secondes.

10. Procédé selon l'une quelconque des revendications précédentes, dans lequel le gaz soufré est choisi parmi éthane-1,2-dithiol (EDT), disulfure de diméthyle (DMDS), disulfure de diéthyle (DEDS), disulfure de dipropyle (DPDS), disulfure de dibenzyle (DBDS), disulfure de di-tert-butyle (DTBDS), tert-butylthiol (t-BuSH), thiophénol et leurs mélanges.

11. Procédé selon l'une quelconque des revendications précédentes, dans lequel l'étape e) est réalisée :
- en présence de dihydrogène, et/ou d'un gaz porteur inerte, en particulier d'argon et/ou d'hélium ; et/ou
- sous activation par plasma.

12. Procédé selon l'une quelconque des revendications précédentes, dans lequel l'étape e) est :
- réalisée pendant une durée de 1 à 20 secondes, en particulier d'environ 10 secondes ; et/ou
- suivie d'une étape f) de purge dudit gaz soufré, laquelle est notamment réalisée :
∘ par passage d'un gaz inerte, notamment d'argon et/ou d'hélium et/ou de diazote ; et/ou
∘ pendant une durée inférieure ou égale à 2 secondes.

13. Procédé selon la revendication 1, lequel comprend les étapes suivantes :
**a)** Une étape d'introduction du substrat dans une enceinte réactionnelle sous vide primaire, à une température de substrat comprise entre 200 et 500°C, notamment à une température comprise entre 360 et 450°C, en particulier à environ 410°C ;
**b)** Une étape de préparation du substrat comprenant l'injection d'un gaz à base de, pris individuellement ou en mélange, dihydrogène, hélium, argon, diazote ou NH₃, pendant une durée de 2 à 900 secondes ;
**c)** Une étape d'injection, dans l'enceinte réactionnelle, d'un mélange gazeux comprenant un hexacarbonyle de tungstène et/ou un hexacarbonyle de Mo, et NH₃, ou d'injection simultanée d'hexacarbonyle de tungstène et/ou un hexacarbonyle de Mo, et de NH₃, pendant une durée de 2 à 20 secondes, en particulier d'environ 10 secondes ;
**d)** Une étape de purge dudit mélange gazeux par passage d'un gaz inerte, notamment d'argon et/ou d'hélium, pendant une durée inférieure ou égale à 2 secondes ;
**e)** Une étape de mise en contact, du substrat traité tel qu'obtenu à l'issue de l'étape c) avec un gaz soufré comportant au moins un groupement thiol libre ou formant un intermédiaire réactionnel comportant au moins un groupement thiol libre, notamment choisi parmi éthane-1,2-dithiol (EDT), disulfure de diméthyle (DMDS), disulfure de diéthyle (DEDS), disulfure de dipropyle (DPDS), disulfure de dibenzyle (DBDS), disulfure de di-tert-butyle (DTBDS), tert-butylthiol (t-BuSH), thiophénol et leurs mélangespour former sur le substrat une couche comprenant le composé de formule WSₓ, MoSₓ ou Mo_{y}W_{1-y}Sₓ, en particulier en présence de dihydrogène, et/ou d'un gaz porteur inerte, en particulier d'argon et/ou d'hélium, et/ou sous activation par plasma, pendant une durée de 1 à 20 secondes, en particulier d'environ 10 secondes :
**f)** Optionnellement, une étape de purge dudit gaz soufré par passage d'un gaz inerte, notamment d'argon et/ou d'hélium et/ou du diazote, pendant une durée inférieure ou égale à 2 secondes.

14. Procédé selon l'une quelconque des revendications précédentes, dans lequel :
- le taux résiduel d'azote de la couche obtenue à l'issue de l'étape e) est inférieur à 5% atomique ;
- l'épaisseur de la couche obtenue à l'issue de l'étape e) étant d'environ 0,7 Å par cycle d'étapes b) à e) ;
- les étapes b) à e) ou éventuellement f) sont renouvelées, jusqu'à obtention du nombre de feuillets désirés, notamment 1 à 20 feuillets, en particulier de 1 à 6, par exemple 3 feuillets ; et/ou
- l'étape e), ou, lorsqu'elle existe, l'étape f), est suivie d'une étape de recuit, en particulier à une température de 700 °C ou plus.

15. Procédé de préparation d'un empilement de couches, comprenant les étapes a) à e) voire f) telles que définies aux revendications 1 à 14, l'étape e), ou, lorsqu'elle existe, l'étape (f), étant suivie d'une étape de recuit, en particulier à une température de 700 °C ou plus, puis d'une étape de dépôt d'une couche d'un nitrure d'élément(s) III ou d'un composé III-V.
